Europäisches Patentamt

European Patent Office

Office européen des brevets

(11) Veröffentlichungsnummer: **0 347 833**
**A2**

(12) **EUROPÄISCHE PATENTANMELDUNG**

(21) Anmeldenummer: **89111182.5**

(22) Anmeldetag: **20.06.89**

(51) Int. Cl.⁴: **H03D 7/00**

(30) Priorität: **23.06.88 DE 3821040**

(43) Veröffentlichungstag der Anmeldung:
**27.12.89 Patentblatt  89/52**

(84) Benannte Vertragsstaaten:
**AT CH DE ES FR GB IT LI NL SE**

(71) Anmelder: **LABORATORIUM PROF. DR. RUDOLF BERTHOLD**
**Calmbacher Strasse 22**
**D-7547 Wildbad 1(DE)**

(72) Erfinder: **Eul, Hermann-Josef, Dipl.Ing.**
**Steeler Strasse 183**
**D-4300 Essen-1(DE)**
Erfinder: **Schiek, Burkhard, Prof. Dr. Dipl.-Ing.**
**Robert-Koch-Strasse 24**
**D-4630 Bochum-1(DE)**

(74) Vertreter: **Frank, Gerhard, Dipl.-Phys.**
**Patentanwälte Dr. F. Mayer & G. Frank**
**Westliche 24**
**D-7530 Pforzheim(DE)**

(54) **Mehrstufiger Einseitenbandversetzer.**

(57) Die Erfindung betrifft eine Anordnung und ein Verfahren zur Realisierung eines mehrstufigen Einseitenbandversetzers. Dazu werden schaltbare Phasenschieber kaskadiert und zeitlich nacheinander in geeignete Reihenfolge in alle möglichen Kombinationen geschaltet.

Besonders geeignete Schaltfolgen der Phasenschalter zeichnen sich dadurch aus, daß eine Austastung der transienten Vorgänge im Niederfrequenzbereich der Vorrichtung möglich ist.

Einsetzbar ist ein solcher Einseitenbandversetzer zum Beispiel in einem homodynen Netzweranalysator, so daß der Mischprozeß ein Zwischenfrequenzsignal mit von null verschiedener Frequenz erzeugt, welches die Amplituden und Phaseninformation des Testsignals trägt.

Da die am Mischer anstehenden Signale aus ein und derselben Quelle abgeleitet sind, ist die Frequenz des Niederfrequenzsignales exakt durch die Wiederholfrequenz der Phasenschaltzustände bestimmt. Diese läßt sich leicht mit elektronischen Mitteln quarzgenau erzeugen. Demzufolge ist das Mischerausgangssignal praktisch keinen Frequenz - schwankungen unterworfen, was eine sofortige Umsetzung in das Basisband erlaubt, wo es aus demselben Grunde sehr schmalbandig filterbar ist. Letzteres führ zu gutem Signal/Rauschabstand, der darüber hinaus noch durch die lediglich einmal auftretenden Konversionsverluste günstig beeinflußt wird.

EP 0 347 833 A2

## Mehrstufiger Einseitenbandversetzer

Die Erfindung betrifft ein Verfahren zur Realisierung eines mehrstufigen Einseitenbandversetzers. Zu diesem Zwecke werden schaltbare Phasenschieber kaskadiert, da die Unterdrückung des unerwünschten Seitenbandes mit steigender Zahl der kaskadierten Phasenschalter zunimmt. Die Anzahl der Phasenschalter werde mit $N$ bezeichnet, die wirksame Stufenzahl des Einseitenbandversetzers sei mit $N_{eff}$ bezeichnet, wenn sie von der Anzahl der Phasenschalter abweicht.

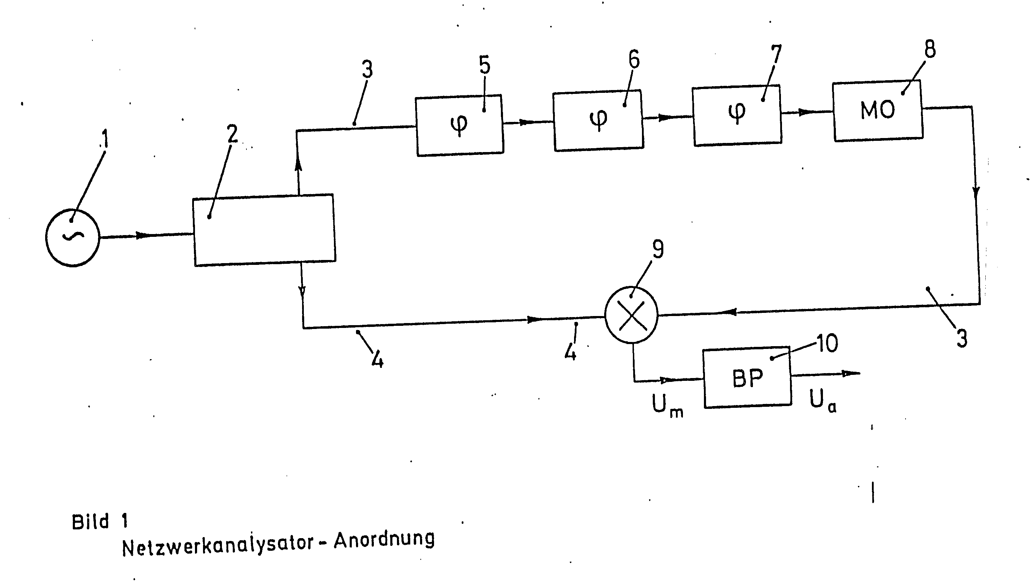

Solche Einseitenbandversetzer werden beispielsweise für die Verwirklichung homodyner Netzwerkanalysatoren eingesetzt. Dabei wird gemäß Bild 1 ein Oszillatorsignal (1) der Frequenz $f_1$ über einen Signalteiler (2) auf einen Meßsignalzweig (3) und einen Referenzsignalzweig (4) aufgeteilt. Im Meßzweig sind die $N$ schaltbaren Phasenschieber, hier z.B. drei an der Zahl, (5),(6) und (7), und das Meßobjekt (8) in Kette geschaltet angeordnet. Die Signale des Referenzzweiges und des Meßzweiges werden in einem Mischer (9) überlagert, so daß ein Zwischenfrequenzsignal der Frequenz $f_0 = |f_2 - f_1|$ entsteht, welches in einem Bandpaß (10) von möglichen Nebenwellen, worunter z.B. Oberwellen oder Subharmonische zu verstehen sind, befreit wird.

Wird der Einseitenbandversetzer erfindungsgemäß betrieben, was bedeutet, daß das frequenzversetzte Nutzsignal bei der Frequenz $f_2 = f_1 \pm f_0$ liegt und daß das zugehörige Spiegelsignal, welches eine Störung darstellt, sehr klein ist, dann ist das bandpaßgefilterte Zwischenfrequenzsignal, welches nach üblichen Methoden nach Betrag und Phase ausgewertet werden kann, dem Signal des Meßzweiges (3) proportional und damit auch ein Maß für die komplexe Transmission $H$ des Meßobjektes (8). Dazu muß in bekannter Weise der Mischer quasilinear betrieben werden, was heißt, daß der Mischer entweder wie ein idealer Multiplizierer arbeitet und/oder das Signal der Referenzzweiges groß gegenüber dem Signal des Meßzweiges sein muß.

Werden die Phasenschalter zunächst sehr langsam geschaltet, so daß quasistationärer Betrieb vorliegt ( $f_2 = f_1$ ), liefert der Mischer an seinem niederfrequenten Ausgang eine Gleichspannung, die ein Maß für den Realteil der komplexen Übertragungsfunktion $H_0 = K_0 H$ des gesamten Signalzweiges ist. Dabei enthält $K_0$ neben der Grunddämpfung und der Grundphase auch den komplexen Konversionsfaktor des Mischers.

Ferner entsteht am Mischerausgang eine Gleichspannung, die sog. Mischer-Offset-Spannung, die als auf geeignete Weise eliminiert oder unwirksam gemacht vorausgesetzt wird. Wie dies im einzelnen geschieht, wird an späterer Stelle deutlich. Unter diesen Voraussetzungen gilt für die Ausgangspannung des Mischers

$$U_{m1} = U_1 = \mathrm{Re}H_0 = \tfrac{1}{2}(H_0 + H_0^*),$$

wobei $H_0^*$ die zu $H_0$ konjugiert komplexe Größe bezeichnet.

Zunächst sei als Beispiel eine Anordnung mit zwei Phasenschaltern betrachtet, bei der die Phasenschalter entkoppelt sind, so daß deren Unschalten durch einen komplexen Faktor $k$ vollständig beschrieben werden kann. Die gesamte Übertragungsfunktion $H_0$ wird durch das Einschalten von Phasenschalter I von $H_0$ auf $H_0 k_1$ verändert, analog gilt für das Einschalten von Phasenschalter II $H_0 \rightarrow H_0 k_2$ . Werden beide Phasenschalter gleichzeitig eingeschaltet, so ist $H_0 \rightarrow H_0 k_1 k_2$ die Folge, so daß sich die zugehörigen Mischerausgangsspannungen zu

$$U_1 = \tfrac{1}{2}(H_0 + H_0^*) \qquad Gl.(1)$$
$$U_2 = \tfrac{1}{2}(H_0 k_1 + H_0^* k_1^*) \qquad Gl.(2)$$
$$U_3 = \tfrac{1}{2}(H_0 k_2 + H_0^* k_2^*) \qquad Gl.(3)$$
$$U_4 = \tfrac{1}{2}(H_0 k_1 k_2 + H_0^* k_1^* k_2^*) \qquad Gl.(4)$$

ergeben. Diese Spannungen werden in geeigneter Weise linear superponiert, so daß sich mit der Definition $p_1 = 1$, $p_2 = p_1$, $p_3 = p_2$ und $p_4 = p_1 p_2$ für die Summenspannung $U_t$

$$
\begin{aligned}
U_t = \sum_{i=1}^{4} p_i U_i &= U_1 + p_1 U_2 + p_2 U_3 + p_1 p_2 U_4 \\
&= \tfrac{1}{2} H_0(1 + p_1 k_1 + p_2 k_2 + p_1 p_2 k_1 k_2) + \tfrac{1}{2} H_0^*(1 + p_1 k_1^* + p_2 k_2^* + p_1 p_2 k_1^* k_2^*) \\
&= \tfrac{1}{2} H_0(1 + p_1 k_1)(1 + p_2 k_2) + \tfrac{1}{2} H_0^*(1 + p_1 k_1^*)(1 + p_2 k_2^*) \qquad Gl.(5)
\end{aligned}
$$

ergibt, die bei geeigneter Wahl der Wichtungsfaktoren $p_1$ und $p_2$ , nämlich gemäß

$$p_1 = -\frac{1}{k_1^{\bullet}}, \qquad p_2 = -\frac{1}{k_2^{\bullet}}, \hspace{3cm} Gl.(6)$$

nur noch der gewünschten Übertragungsfunktion $H$ proportional ist, nicht aber mehr $H^{\ast}$. Denn unter der Voraussetzung von Gl. (6) gilt

$$U_\ell = \tfrac{1}{2} K_0 H (1 - \frac{k_1}{k_1^{\bullet}})(1 - \frac{k_2}{k_2^{\bullet}}), \hspace{3cm} Gl.(7)$$

worin die Proportionalitätskonstante

$$\tfrac{1}{2} K_0 (1 - \frac{k_1}{k_1^{\bullet}})(1 - \frac{k_2}{k_2^{\bullet}})$$

durch eine Kalibriermessung ohne Meßobjekt bestimmt wird.

Allgemein, also mit N Phasenschaltern, sind $2^N$ verschiedene Schaltzustände möglich, so daß die Spannungen $U_i$, $i = 1...2^N$, gemessen werden, die zur Summenspannung $U_\ell$ gemäß

$$U_\ell = \sum_{i=1}^{2^N} p_i U_i \hspace{3cm} Gl.(8)$$

$$= \tfrac{1}{2} H_0 \prod_{i=1}^{2^N} (1 + p_i k_i) + \tfrac{1}{2} H_0^{\bullet} \prod_{i=1}^{2^N} (1 + p_i k_i^{\bullet}) \hspace{2cm} Gl.(9)$$

aufsummiert werden, welche sich unter den Bedingungen

$$p_i = -\frac{1}{k_i^{\bullet}}, \qquad i = 1...2^N \hspace{3cm} Gl.(10)$$

zu

$$U_\ell = \tfrac{1}{2} H_0 \prod_{i=1}^{2^N} (1 + p_i k_i) \hspace{3cm} Gl.(11)$$

vereinfacht.

Werden die Wichtungsfaktoren jedoch nicht exakt gemäß Gl. (10) gewählt, dann ist die Summenspannung $U_\ell$ von $H_0^{\bullet}$ gestört, und zwar umso weniger, je mehr Faktoren die Produkte in Gl. (9) haben, da der Störterm dann von immer höherer Ordnung klein wird, weil auch bei Abweichungen von der Bedingung gemäß Gl. (10) noch immer $(1 + p_i k_i^{\ast}) \ll 1$ gilt. Da sich auch eine mangelnde Entkopplung der Phasenschalter wie eine Abweichung von den exakten Wichtungsfaktoren auswirkt, kann auf die Entkopplung mit zunehmender Stufenzahl mehr und mehr verzichtet werden.

Die Auswertung der Mischerausgangsspannungen gemäß Gl. (8) kann dadurch erfolgen, daß die $U_i$ sequentiell gemessen und rechnerisch gewichtet aufsummiert werden. Für schnelle Anwendungen ist diese Vorgehensweise jedoch zu zeitintensiv, wobei hier sowohl die transienten Vorgänge im Filter als auch die endliche Wandelrate der Digital-Analog-Wandler als Hauptursache zu nennen sind.

Gegenstand dieser Erfindung ist es, die gewichtete Summe analog auf eine geeignete Weise schnell und genau zu bilden. Dazu werden die Phasenschalter derart eingestellt, daß der Betrag ihrer Übertragungsfunktion möglichst in beiden Stellungen gleich ist, also $|k_i| \simeq 1$, $i = 1...N$, gilt. Ferner werden geeignete Phasenschaltwerte gewählt, z.B.

$k_1 = e^{\pm j180^{\circ}}, k_2 = e^{\pm j90^{\circ}}, k_3 = e^{\pm j45^{\circ}}, ...k_N = e^{\pm j360^{\circ}/2^N}, \qquad Gl.(12)$

worin beliebige Kombinationen der Vorzeichen der Exponenten gewählt werden können; die folgenden Beispiele verwenden die positiven Werte.

Eine Besonderheit ist für den Fall $arc(k) = 180°$ zu beachten, denn wegen

$$k_{180}^{*} = k_{180}$$

kann der zugehörige Wichtungsfaktor nicht gemäß Gl. (10) gewählt werden. Möglich ist dann z.B. der Wichtungsfaktor

$$p_{180} = + \frac{1}{k_{180}^{*}}, \qquad Gl.(13)$$

wobei dieser Phasenschalter dann nicht mehr zur Unterdrückung des Störterms beiträgt, so daß sich für die Stufenzahl $N_{eff}$ des Einseitenbandversetzers mit $N$ Phasenschaltern

$$N_{eff} = N - 1 \qquad Gl.(14)$$

ergibt. Beispielsweise wirkt eine Schaltung mit den Phasenschaltwerten $180°, 90°, 45°$, also mit $N = 3$, effektiv nur als zweistufige Anordnung, $N_{eff} = 2$.

Trotzdem erfüllt der $180°$-Schalter wichtige Funktionen, indem er zur Beseitigung der Mischer-Offset-Spannung beiträgt und den Wirkungsgrad des Einseitenbandversetzers erhöht. Prinzipiell könnte dieser Phasenschalter auch durch einen Amplitudenmodulator ersetzt werden, der die Zustände 'Ein' und 'Aus' in derselbe Weise annimmt wie der Phasenschalter die Zustände $0°$ und $180°$, so daß die Stufenzahl des Einseitenbandversetzers wieder identisch mit der Anzahl der Phasenschieber wäre.

An dieser Stelle sei angemerkt, daß mit diesen Phasenschaltwerten auch die bekannte Treppenfunktion [1] nachgebildet werden könnte. Dies geschieht aber nicht, da dann unabhängig von der Stufenzahl $N$ immer nur ein Einseitenbandversetzer mit $N_{eff} = 1$ realisiert würde. Ferner zeigt diese Anordnung nicht die mit der Stufenzahl $N$ zunehmende Unempfindlichkeit auf Abweichungen von den exakten Schaltwerten.

Zum Verständnis der analogen Realisierung von Gleichung (8) wird diese nun anhand eines zweistufigen Einseitenbandversetzers mit drei Phasenschaltern beschrieben, also $N = 3$, $N_{eff} = 2$. Die Wichtungsfaktoren sind gemäß Gl. (10) wie folgt zu wählen:

$$
\begin{array}{llllll}
— & \rightarrow & p_1 & = & 1 & = e^{j0°} & \rightarrow U_1 \\
I & \rightarrow & p_2 = p_1 & = & \dfrac{1}{k_1^{*}} & = e^{-j180°} & \rightarrow U_2 \\
II & \rightarrow & p_3 = p_2 & = & -\dfrac{1}{k_2^{*}} & = e^{-j90°} & \rightarrow U_3 \\
III & \rightarrow & p_4 = p_3 & = & -\dfrac{1}{k_3^{*}} & = e^{-j135°} & \rightarrow U_4 \\
I, \; II & \rightarrow & p_5 = p_1 p_2 & = & -\dfrac{1}{k_1^{*} k_2^{*}} & = e^{-j270°} & \rightarrow U_5 \\
I, \; III & \rightarrow & p_6 = p_1 p_3 & = & -\dfrac{1}{k_1^{*} k_3^{*}} & = e^{-j315°} & \rightarrow U_6 \\
II, \; III & \rightarrow & p_7 = p_2 p_3 & = & \dfrac{1}{k_2^{*} k_3^{*}} & = e^{-j225°} & \rightarrow U_7 \\
I, \; II, \; III & \rightarrow & p_8 = p_1 p_2 p_3 & = & \dfrac{1}{k_1^{*} k_2^{*} k_3^{*}} & = e^{-j45°} & \rightarrow U_8.
\end{array}
$$

$$Gl.(15)$$

Diese acht Schaltzustände werden mit der Frequenz $f_0 = 1/T_0$ periodisch in geeigneter Reihenfolge eingeschaltet. Die Dauer jeder aktiven Phase sei mit $\Delta\tau$ bezeichnet, der zeitliche Abstand zwischen zwei aufeinanderfolgenden aktiven Phasen betrage $\tau$, wobei gilt:

$$\Delta\tau \leq \tau, \qquad \tau = \frac{T_0}{N}. \qquad Gl.(16)$$

4

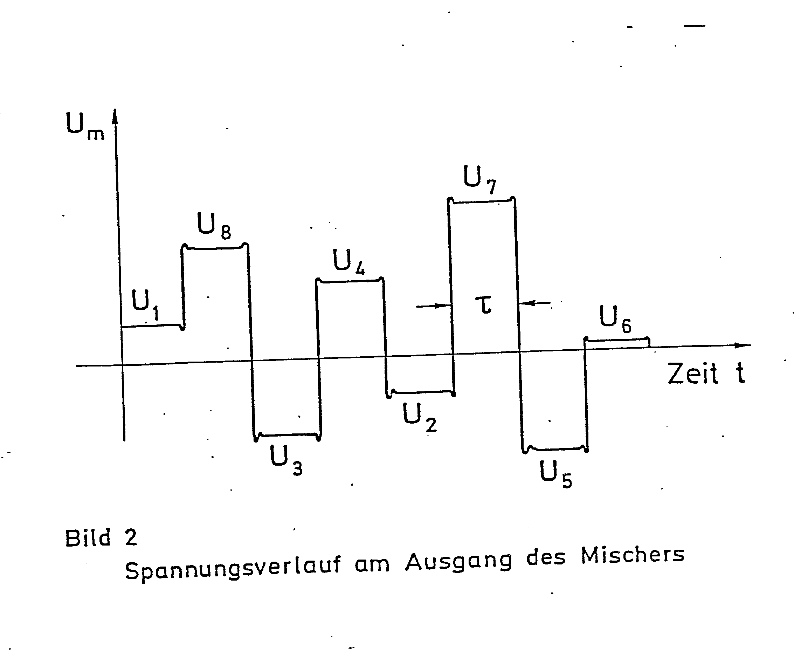

In Bild 2 ist ein Spannungsverlauf, wie er am Mischerausgang obiger Anordnung auftreten kann, dargestellt; die Spannungen der Plateaus stimmen mit den Spannungen $U_1, ..., U_8$ überein, wobei allerdings eine geeignete Reihenfolge einzuhalten ist, die hier in der Art

$$U_m(t) = U_1 \xrightarrow{\tau} U_8 \xrightarrow{\tau} U_3 \xrightarrow{\tau} U_4 \xrightarrow{\tau} U_2 \xrightarrow{\tau} U_7 \xrightarrow{\tau} U_5 \xrightarrow{\tau} U_6 \qquad Gl.(17)$$

zu wählen ist. Aus Gl. (17) wird in Verbindung mit Gl. (15) deutlich, daß der jeweils gültige Wichtungsfaktor $p_i$ sich bei jedem Schritt um den Faktor $e^{-j45°}$ bzw. allgemein $e^{-j360°/2^N}$ ändert. Das heißt, die Schaltsignale werden zeitlich so angeordnet, daß für ihre Startzeiten

$$t_i = -\frac{arc(\rho_i)}{360°}T_0 - \frac{T_0}{N} - t_0 \quad \text{mit}, \ i = 1, 2, \ldots N \qquad Gl.(18)$$

gilt, wobei $t_0$ eine beliebige Startzeit ist. Wie bei dieser Wahl der Vorzeichen der Exponenten in Gl. (12) gilt auch für andere, daß unter den $p_i$ jedes Vielfache von $360°/2^N$ genau einmal auftritt.

Aus dem Mischerausgangssignal wird durch einen hinreichend schmalen, niederfrequenten Bandpaß der Mittenfrequenz $f_0 = 1/T_0$ das Signal $U_a$ bei der Grundfrequenz $f = f_0$ herausgefiltert, welche der Summenspannung $U_I$ und damit der komplexen Übertragungsfunktion nach Betrag und Phase proportional ist.

Durch die gezeigte zeitliche Anordnung der Schaltzustände und durch die Bandpaßfilterung wird somit erreicht, daß das Signal $U_a$ in gleicher Weise gewichtet ist wie die Summenspannung $U_I$ nach Gleichung (8).

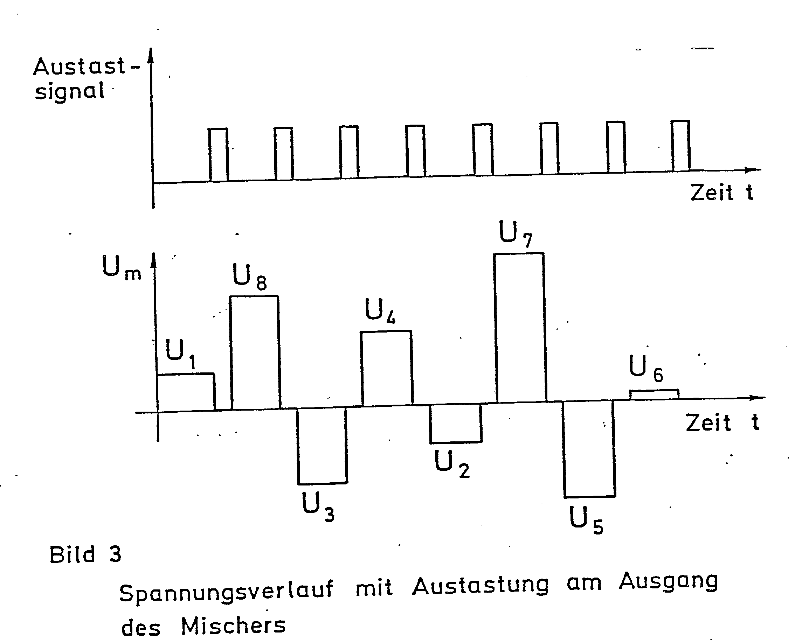

Wird eine zeitliche Anordnung gewählt, bei der nicht alle Zeitpunkte einer Periode besetzt sind, dann müssen diese Stellen durch einen Austastmechanismus unwirksam gemacht werden. Ist die Besetzung äquidistant, kann die Austastung auf der Niederfrequenzseite des Systems vorgenommen werden, anderenfalls hat sie auf der Hochfrequenzseite zu erfolgen. Aber auch im Falle lückenlos besetzter Zeitachse ist eine Austastung empfehlenswert, und zwar derart, daß sie transiente Vorgänge beim Umschalten zwischen den einzelnen Zuständen ausblendet. In diesen Fällen gilt $\Delta\tau < \tau$, Bild 3. Während eine Mischer-Offset-Spannung selbst schon wegen der Auswertung des Signals mit der Frequenz $f = f_0$ nicht stört, tritt auch durch das niederfrequente, periodische Austastsignal keine Störung ein, denn dieses erzeugt nur Störsignale bei Oberwellen von $f_0$, welche durch die Bandpaßfilterung eliminiert werden.

Das sinusförmige Ausgangssignal $U_a$ des Bandpasses ist mit zunehmender Stufenzahl ein zunehmend gutes Maß der komplexen Übertragungsfunktion des Hochfrequenzzweiges (3), und zwar nach Betrag und Phase. Diese Anordnung der geschalteten Phasenschieber stellt also einen nahezu idealen Einseitenbandversetzer dar, dessen oberes Seitenband $f = f_1 + f_0$ von großer und dessen unteres Seitenband $f = f_1-f_0$ von sehr kleiner Amplitude ist. Um das obere Seitenband zu unterdrücken, muß die Abfolge der Phasenschaltzustände zeitlich invertiert werden.

In Abwandlung der oben beschiebenen Schaltung können einzelne oder alle Phasenschieber in dem Referenzzweig angebracht werden, wobei zu beachten ist, daß in diesem Falle die Wichtungsfaktoren gemäß

$$p_i = -\frac{1}{k_i}, \quad i = 1, \ldots N \qquad Gl.(19)$$

zu wählen sind.

Ferner kann in Abwandlung des oben beschriebenen Verfahrens eine andere günstige Wahl der Phasenschaltwerte vorgenommen werden, und zwar
$k_1 = e^{j180°}, k_2 = k_3 = e^{\pm j90°}. \quad Gl.(20)$
Analog zu oben bestimmen sich bei der Verwendung des positiven Vorzeichens die Wichtungsfaktoren zu

$$
\begin{array}{lllll}
- & \rightarrow & \rho_1 & = & 1 & = & e^{j0°} & \rightarrow U_1 \\
\text{I} & \rightarrow & \rho_2 = p_1 & = & \dfrac{1}{k_1^\bullet} & = & e^{-j180°} & \rightarrow U_2 \\
\text{II} & \rightarrow & \rho_3 = p_2 & = & -\dfrac{1}{k_2^\bullet} & = & e^{-j90°} & \rightarrow U_3 \\
\text{III} & \rightarrow & \rho_4 = p_3 & = & -\dfrac{1}{k_3^\bullet} & = e^{-j90°} = & e^{-j450°} & \rightarrow U_4 \\
\text{I, II} & \rightarrow & \rho_5 = p_1 p_2 & = & -\dfrac{1}{k_1^\bullet k_2^\bullet} & = & e^{-j270°} & \rightarrow U_5 \\
\text{I, III} & \rightarrow & \rho_6 = p_1 p_3 & = & -\dfrac{1}{k_1^\bullet k_3^\bullet} & = e^{-j270°} = & e^{-j630°} & \rightarrow U_6 \\
\text{II, III} & \rightarrow & \rho_7 = p_2 p_3 & = & \dfrac{1}{k_2^\bullet k_3^\bullet} & = e^{-j180°} = & e^{-j540°} & \rightarrow U_7 \\
\text{I, II, III} & \rightarrow & \rho_8 = p_1 p_2 p_3 & = & \dfrac{1}{k_1^\bullet k_2^\bullet k_3^\bullet} & = & e^{-j360°} & \rightarrow U_8,
\end{array}
$$

$$Gl.(21)$$

so daß so geschaltet werden muß, daß die Spannungen gemäß

$$
U_m(t) = U_1 \xrightarrow{T} U_3 \xrightarrow{T} U_2 \xrightarrow{T} U_5 \xrightarrow{T} U_6 \xrightarrow{T} U_4 \xrightarrow{T} U_7 \xrightarrow{T} U_8 \qquad Gl.(22)
$$

zeitlich nacheinander folgen.

Wegen der Gleichheit zweier Wichtungsfaktoren, werden hier die Zustände und somit die Rechtecksignale der Amplituden $U_i$ über zwei Perioden des niederfrequenten Signals verteilt, hier auf Grund der speziellen Wahl der Phasenschaltwerte im Abstand einer Viertel Periode. Die Verteilung der Schaltzustünde über zwei Perioden hat zur Folge, daß Signale bei der Frequenz $f = f_0/2$ auftreten, so daß das Bandpaßfilter so ausgelegt werden muß, daß es bei den Frequenzen $f = f_0/2$, $3f_0/2$ bereits genügend hohe Dämpfung gewährleistet.

Auch hier kann der $180°$-Schalter durch einen Amplitudenmodulator im Hochfrequenzzweig ersetzt werden, so wie auch einzelne Phasenschalter wieder in den Referenzzweig gelegt werden können.

Literatur

[1] JAFFE, J.S., MACKEY, R.C., Microwave Frequency Translator, IEEE MTT 13, 1965, pp. 371 - 378

**Ansprüche**

1. Anordnung und Verfahren zur Realisierung eines mehrstufigen Einseitenbandversetzers, gekennzeichnet durch die Kaskadierung von $N$ schaltbaren Phasenschiebern, wobei $N$ eine positive, von Null verschiedene ganze Zahl ist, die zeitlich nacheinander in geeigneter Reihenfolge in alle möglichen zwei hoch $N$ Kombinationen geschaltet werden, wobei sich die Schaltfolge periodisch wiederholt sowie durch eine zeitlich umgekehrte Abfolge zur Erzeugung des jeweils anderen Seitenbandes.

2. Anordnung und Verfahren nach Anspruch 1, gekennzeichnet durch die spezielle Wahl der Abfolge derart, daß sich die jeweilige Position nach einem Schema bestimmt, das durch die folgenden Merkmale gekennzeichnet ist:

a. Für jede mögliche Kombination der Phasenschalterstellungen wird eine charakteristische Größe, hier als Summenphase bezeichnet, derart berechnet, daß die Phasenverschiebungen, in Grad gemessen, aufsummiert und durch Hinzufügen oder Abziehen von Vielfachen von dreihundertsechzig Grad auf einen Bereich von Null bis minus dreihundertsechzig Grad umgerechnet werden.

b. Die Summenphase aus 2.a. ist um plus oder minus einhundertachtzig Grad zu verändern, wenn die Anzahl der aktiven Phasenschalter ungerade ist.

c. Die Summenphase aus 2.a. ist gegebenenfalls um weitere plus oder minus einhundertachtzig Grad zu verändern, wenn einer der aktivierten Phasenschalter ein Einhundertachtzig-Grad-Schalter ist.

d. Nach den durch 2.a. bis 2.c. bestimmten Summenphasen werden die Schaltkombinationen derart geordnet, daß die zugehörigen Summenphasen monoton fallen, wobei bei mehrfach auftretenden Summenphasenwerten nur eine Kombination entsprechend diesem Wert eingeordnet werden darf und die anderen Summenphasen durch Hinzufügen von minus dreihundertsechzig Grad so oft zu modifizieren sind, bis keine Mehrdeutigkeit mehr vorliegt.

e. Die Schaltkombinationen werden in der durch Anspruch 2.d. festgelegten Reihenfolge zeitlich nacheinander mit jeweils gleicher Dauer, nicht überlappend aktiviert, und zwar derart, daß ihr Startzeitpunkt, oder ein anderer einheitlicher Bezugspunkt, proportional zu den zugehörigen modifizierten Summenphasenwerten gewählt wird, und zwar derart, daß negativere Summenphasenwerte zu zeitlich späteren Aktivierungszeiten führen.

f. Zu den Zeiten, zu denen keiner der möglichen zwei hoch $N$ Zustände aktiviert ist, hat eine Austastung des Signales zu erfolgen.

3. Anordnung und Verfahren gemäß Anspruch 1 und Anspruch 2, gekennzeichnet durch die Verwendung von Phasenschaltern, die sich durch fortgesetzte Division von dreihundertsechzig Grad durch zwei ergeben, wodurch sich eine lückenlose Besetzung der Zeitachse ergibt.

4. Anordnung und Verfahren gemäß Anspruch 1 und Anspruch 2, gekennzeichnet durch die Verwendung eines Einhundertachtzig-Grad-Phasenschalters und mehrerer Neunzig-Grad-Phasenschalter.

5. Anordnung und Verfahren zur Realisierung eines homodynen Netzwerkanalysators, dadurch gekennzeichnet, daß ein monofrequentes Oszillatorsignal in einen Meßzweig und einen Referenzzweig aufgeteilt wird, wobei in einem der beiden Zweige der Einseitenbandversetzer gemäß den Ansprüchen 1 bis 4 eingefügt ist, und diese beiden Signale in einem Mischer überlagert werden, wodurch an dessen Ausgang ein niederfrequentes Signal entsteht, das nach Bandpaßfilterung als Sinussignal die Informationen des hochfrequenten, versetzten Signales nach Betrag und Phase enthält.

6. Anordnung und Verfahren gemäß Anspruch 5, abweichend durch das Kennzeichen, daß die Phasenschalter auf die beiden Zweige verteilt sind.

7. Anordnung und Verfahren nach Anspruch 5 und Anspruch 3 oder Anspruch 4, gekennzeichnet durch die Verwendung eines Ein-Aus-Schalters auf der Niederfrequenzseite, angeordnet zwischen Mischer und Bandpaß, welcher periodisch in den Übergangszeiten von einem Phasenschaltzustand in einen anderen eine Austastung vornimmt, sowie zwischen diesen Austastzeiten eine beliebige, aber immer gleiche Amplitudenwichtung vornehmen darf.

**Bild 1**
Netzwerkanalysator - Anordnung

EP 0 347 833 A2

**Bild 2**

Spannungsverlauf am Ausgang des Mischers

**Bild 3**

Spannungsverlauf mit Austastung am Ausgang des Mischers